(19)

Europäisches
Patentamt
European
Patent Office
Office européen
des brevets

(11)　EP 2 092 675 B1

(12)　EUROPEAN PATENT SPECIFICATION

(45) Date of publication and mention
of the grant of the patent:
**05.01.2011 Bulletin 2011/01**

(51) Int Cl.:
**H04L 1/00** *(2006.01)*　　**H03K 19/173** *(2006.01)*
**H03M 13/03** *(2006.01)*

(21) Application number: **07849092.7**

(22) Date of filing: **12.11.2007**

(86) International application number:
**PCT/IB2007/054588**

(87) International publication number:
**WO 2008/059431 (22.05.2008 Gazette 2008/21)**

(54) **INTEGRATED CIRCUIT TO ENCODE DATA**

INTEGRIERTE SCHALTUNG ZUM CODIEREN VON DATEN

CIRCUIT INTÉGRÉ POUR CODER DES DONNÉES

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **14.11.2006 EP 06291775**

(43) Date of publication of application:
**26.08.2009 Bulletin 2009/35**

(73) Proprietor: **NXP B.V.
5656 AG Eindhoven (NL)**

(72) Inventors:
- **GANDER, Martial, c/o NXP Semiconductors, IP
Dept.
Redhill, Surrey RH1 5HA (GB)**
- **ARDICHVILI, Emmanuel, c/o NXP
Semiconductors
Redhill, Surrey RH1 5HA (GB)**

(74) Representative: **Schuffenecker, Thierry
120 Chemin de la Maure
06800 Cagnes sur Mer (FR)**

(56) References cited:
**EP-A- 1 381 179　　US-A- 5 703 882
US-A1- 2001 025 358　　US-B1- 6 751 772**

**Description**

FIELD OF THE INVENTION

The present invention relates to integrated circuit to encode data.

BACKGROUND OF THE INVENTION

There exist integrated configurable circuits to encode data according to any one of a plurality of coding schemes and/or to generate cycle redundancy codes. Typically, the code scheme comprises block, convolutional and turbo codes.
Ideally such a circuit should be very flexible, that is able to be configured to execute many different coding schemes and/or to generate many different cyclic redundancy codes. This circuit should also excel in the efficient execution (power, chip area, flexibility) of these schemes. However, flexibility and execution efficiency are antagonized. For example, more flexible is the circuit, slower is the execution speed. In contrast, faster is the circuit, lesser is the flexibility. Attempts to build circuits which are pretty flexible while remaining pretty fast have been disclosed. For example, US 6,807,155 in the name of Subramanian discloses to rank functions which are common to different telecommunication processing standards according to their computational intensity. Then the design of the telecommunication processing is based on the function ranking to speed up the execution while remaining pretty flexible.
US 2001/025358 A1 (EIDSON DONALD BRIAN [US] ET AL) discloses an iterative decoder employing multiple external code error checks to lower the error floor and/or improve decoding performance. Data block redundancy, sometimes via a cyclic redundancy check (CRC) or Reed Solomon (RS) code, enables enhanced iterative decoding performance, Improved decoding performance is achieved during interim iterations before the final iteration.
US 6 751 772 B1 (KIM MIN-GOO [KR] ET AL) discloses a device and method for rate matching channel-encoded symbols in a data communication system. The rate matching device and method can be applied to a data communication system which uses one or both of a non-systematic code (such as a convolutional code or a linear block code) and a systematic code (such as a turbo code).
US 5 703 882 A (JUNG HEE YOUNG [KR] ET AL) discloses a modified cyclic line coding apparatus for error detection and frame recovery which generates a n-bit modified cyclic cord-word by use of k redundancy bits and partially scrambles the cyclic redundancy check bits using periodic scramble bits.
EP 1 381 179 A (MATSUSHITA ELECTRIC IND CO LTD [JP]) discloses an audio encoder converts an input sound signal into a plurality of compressed frame data pieces in an sound signal compression coder, determines the importance of each bit in a classification unit of a transmission line coder based on the decoding quality in the presence of a transmission error, and classifies the bits into a plurality of classes.

SUMMARY OF THE INVENTION

Accordingly, it is an object of the invention to provide an integrated circuit which is more flexible than dedicated hardware integrated processors while being faster than non-dedicated hardware processors and less power-hungry.
The invention provides an integrated circuit configurable to encode data according to any one of the coding schemes chosen in a predetermined plurality of coding schemes and to generate cyclic redundancy codes, said predetermined plurality of coding schemes comprising block, convolutional and turbo codes, wherein the integrated circuit comprises:

  a) a plurality of specific hardware cells, each cell comprising:

  • outputs $S_{ij}$, $FO_{ij}$, $BO_{ij}$ and $TO_{ij}$ for binary signals,
  • inputs $E_{ij}$, $BI_{ij}$, $FI_{ij}$ and $TI_{ij}$ for binary signals,
  • a buffer to delay by one clock period a binary value received on input $E_{ij}$ and to output a one-clock period delayed binary value E*,
  • binary adders to perform XOR operations,
  • configurable multiplexers BM, FM, MM and TM connecting the outputs, the inputs, the buffer and the adders to each other according to several configurable paths, the characteristic equations of the cell being:

  •

$$TO_{ij} = S_{ij} = Ctm.TI_{ij} + !Ctm. OutputMux4$$

- 

$$\text{OutputMux4} =$$
$$\text{Cmm0 . Cmm1 . E*} + \text{!Cmm0 . Cmm1 . (E* XOR BI}_{ij}) +$$
$$\text{Cmm0 . !Cmm1 . E} + \text{!Cmm0 . !Cmm1 . (E}_{ij} \text{ XOR FI}_{ij})$$

- 

$$\text{BO}_{ij} = \text{Cbm . (S}_{ij} \text{ XOR BI}_{ij}) + \text{!Cbm . BI}_{ij}$$

ij
or

$$\text{BO}_{ij} = \text{Cbm0 . Cbm1 . (S}_{ij} \text{ XOR BI}_{ij}) + \text{!Cbm0 . Cbm1 . BI}_{ij} +$$
$$\text{!Cbm0 . Cbm1 . S}_{ij}$$

- 

$$\text{FO}_{ij} = \text{Cfm . (S}_{ij} \text{ XOR FI}_{ij}) + \text{!Cfm . FI}_{ij}$$

where:

- $S_{ij}$, $FO_{ij}$, $BO_{ij}$ and $TO_{ij}$ are the binary signals output on outputs $S_{ij}$, $FOi_{j3}$ $BO_j$ and $TO_{ij}$, respectively,
- $E_{ij}$, $BI_{ij}$, $FI_{ij}$ and $TI_{ij}$ are the binary signals received on inputs $E_{ij}$, $BI_{ij}$, $FI_{ij}$ and $TI_{ij}$, respectively,
- "!" is the NOT operation,
- "*" is the output of the buffer,
- "XOR" is the XOR operation,
- "+" is the OR operation,
- "." is the AND operation,
- Cbm, Cbm0, Cbm1, Cfm, Cmm0, Cmm1 and Ctm are respective binary values that represent the configuration of each multiplexer,

b) controllable switch matrices external to each cell and able:

- to electrically connect and, alternatively, to electrically disconnect input $E_{ij}$ to/from at least the output $S_{ij}$ of another cell and to electrically connect and, alternately, to electrically disconnect input $E_{ij}$ to/from an external binary data source,
- to electrically connect and, alternately, to electrically disconnect at least input $FI_{ij}$ to/from at least the output $FO_{ij}$ of another cell,
- to connect and, alternately, to disconnect input $BI_{ij}$ to/from at least the output $BO_{ij}$ of another cell.

The invention also provides an integrated circuit configurable to encode data according to any one of the coding schemes chosen in a predetermined plurality of coding schemes and to generate cyclic redundancy codes, said predetermined plurality of coding schemes comprising block and convolutional codes, wherein the integrated circuit comprises :

a) a plurality of specific hardware cells, each cell comprising:

• outputs $S_{ij}$, $FO_{ij}$, and $BO_{ij}$ for binary signals,

3

• inputs $E_{ij}$, $BI_{ij}$, and $FI_{ij}$ for binary signals,
• a buffer to delay by one clock period a binary value received on input $E_{ij}$ and to output a one-clock period delayed binary value $E^*$,
• binary adders to perform XOR operations,
• configurable multiplexers connecting the outputs, the inputs, the buffer and the adders to each other according to several configurable paths, the characteristic equations of the cell being:

•

$$S_{ij} = OutputMux4$$

•

$$OutputMux4 =$$
$$Cmm0 . Cmm1 . E^* + !Cmm0 . Cmm1 . (E^* \text{ XOR } BI_{ij}) +$$
$$Cmm0 . !Cmm1 . E + !Cmm0 . !Cmm1 . (E_{ij} \text{ XOR } FI_{ij})$$

•

$$BO_{ij} = Cbm . (S_{ij} \text{ XOR } BI_{ij}) + !Cbm . BI_{ij}$$

or

$$BO_{ij} = Cbm0 . Cbm1 . (S_{ij} \text{ XOR } BI_{ij}) + !Cbm0 . Cbm1 . BI_{ij} + !Cbm0 . Cbm1 . S_{ij}$$

•

$$FO_{ij} = Cfm . (S_{ij} \text{ XOR } FI_{ij}) + !Cfm . FI_{ij}$$

where:

- $S_{ij}$, $FO_{ij}$ and $BO_{ij}$ are the binary signals output on outputs $S_{ij}$, $FO_{ij}$ and $BO_{ij}$, respectively,
- $E_{ij}$, $BI_{ij}$ and $FI_{ij}$ are the binary signals received on inputs $E_{ij}$, $BI_{ij}$ and $FI_{ij}$, respectively,
- "!" is the NOT operation,
- "*" is the output of the buffer,
- "XOR" is the XOR operation,
- "+" is the OR operation,
- "." is the AND operation,
- Cbm, Cbm0, Cbm1, Cfm, Cmm0, and Cmm1 are respective binary values that represent the configuration of each multiplexer,

b) controllable switch matrices external to each cell and able:

- to electrically connect and, alternatively, to electrically disconnect input $E_{ij}$ to/from at least the output $S_{ij}$ of another cell and to electrically connect and, alternately, to electrically disconnect input $E_{ij}$ to/from an external binary data source,
- to electrically connect and, alternately, to electrically disconnect at least input $FI_{ij}$ to/from at least the output $FO_{ij}$ of another cell,
- to connect and, alternately, to disconnect input $Bi_{ij}$ to/from at least the output $BO_{ij}$ of another cell.

The above integrated circuits are more flexible than any dedicated hardware processor because cells and connections between cells can be configured to implement a great number of coding schemes and CRC (Cyclic Redundancy Code) scheme. The above integrated circuit is also faster than any general purpose hardware processor like DSP (Digital Signal Processor), because it comprises specific hardware cells able to execute operations as fast as dedicated hardware processors.

Finally, because specific cells are identical to each other, the implementation on the die of a chip of such an integrated circuit can be done with a great efficiency. Furthermore, the configuration of these cells as well as the configuration of the connections between cells is also made easier.

The embodiments of the above integrated circuits may comprise one or several of the following features:

- the integrated circuit comprises a plurality of clusters $CL_j$, each cluster $CL_j$ comprising:

  - inputs $E_j$, $FI_j$ and $BI_j$,
  - outputs $S_j$, $BO_j$ and $FO_j$,
  - a succession of at least two cells $C_{ij}$ successively electrically connected to each other, the first cell of the succession having its inputs $E_{ij}$ and $FI_{ij}$ and its output $BO_{ij}$ directly connected to inputs $E_j$, $FI_j$ and $BO_j$, respectively, the last cell of the succession having its input $BI_{ij}$ and its outputs $S_{ij}$ and $FO_{ij}$ directly connected to input $BI_j$, output $S_j$ and output $FO_j$, respectively of another cell outside this cluster, and
    any cell other than the last cell having its input $BI_{ij}$ and its outputs $S_{ij}$ and $FO_{ij}$ connected, without any configuration possibility, to output $BO_{ij}$ and inputs $E_{ij}$ and $FI_{ij}$ of the following cell of the succession, respectively, and
  - the switch matrix is only able to configure the electrical connections between cluster inputs and outputs without being able to configure the electrical connections between cells within a cluster,
  - the outputs $S_j$, $FO_j$ and the input $BI_j$ of at least one cluster are connected to inputs $E_j$, $FI_j$ and output $BO_j$ of another cluster without configuration possibility, respectively,
- the integrated circuit comprises between five to ten clusters and each cluster is composed of five cells,
- each cluster has at least one cell having the following characteristic equation:

$$BO_{ij} = Cbm0 \cdot Cbm1 \cdot (S_{ij} \text{ XOR } BI_{ij}) + !Cbm0 \cdot Cbm1 \cdot BI_{ij} + !Cbm0 \cdot Cbm1 \cdot S_{ij}$$

- the inputs $TI_{ij}$ of the succession of cells of a cluster, are directly connected to respective outputs $TO_{ij}$ of the succession of cells of another cluster without any configuration possibility.

The above embodiments of the integrated circuit present the following advantages:

- using cluster reduces the size of the switch matrices,
- connecting a cluster to another cluster without configuration possibility also reduces the size of the switch matrices,
- using between five to ten clusters of five cells constitutes an optimum implementation of the integrated circuit to achieve the greatest possible flexibility while still maintaining the number of cells as small as possible,
- having only one cell in each cluster that corresponds to the characteristic equation

.

$$BO_{ij} = Cbm0.Cbm1. (S_{ij} \text{ XOR } BI_{ij}) + !Cbm0.Cbm1.BI_{ij} + !Cbm0.Cbm1.S_{ij}$$

is enough to configure the integrated circuit to generate CRC codes,
- connecting outputs $TO_{ij}$ to inputs $TI_{i,j+2}$ without any configuration possibility simplifies the connections between adjacent clusters while still maintaining a high degree of flexibility.

These and other aspects of the invention will be apparent from the following description, drawings and claims.

BRIEF DESCRIPTION OF THE DRAWINGS

Figures 1 and 2 are schematic diagram of a first cell and a second cell used in the implementation of an integrated circuit,
Figure 3 is a schematic diagram of a cluster built from cells of Figures 1 and 2,
Figure 4 is an example schematic diagram of an integrated circuit built from the cluster of Figure 3,
Figure 4A is a schematic illustration of a switch matrix implemented within the circuit of Figure 4,
Figure 5 is an illustration of a first configuration of the circuit of Figure 4 to generate a CRC code,
Figure 6 is a schematic diagram of a convolutional encoder,
Figure 7 is a schematic diagram of the configuration of the integrated circuit of Figure 4 to implement the convolutional encoder of Figure 6,
Figure 8 is a schematic diagram of another conventional encoder,
Figure 9 is a schematic diagram of the configuration of the integrated circuit of Figure 4 to implement the convolutional encoder of Figure 8,
Figure 10 is a schematic diagram of another convolutional encoder with inter-branch connections,
Figure 11 is a schematic diagram of the configuration of the integrated circuit of Figure 4 to implement the convolutional encoder of Figure 10, Figure 12A is a schematic diagram of a turbo coder,
Figure 12B is a schematic diagram of the configuration of the integrated circuit of Figure 4 to implement the convolutional turbo coder,
Figure 13A is a schematic diagram of a randomization or scrambling circuit, and
Figure 13B is a schematic diagram of the integrated circuit of Figure 4 configured to implement the randomization or scrambling circuit of Figure 13A.

DETAILED DESCRIPTION

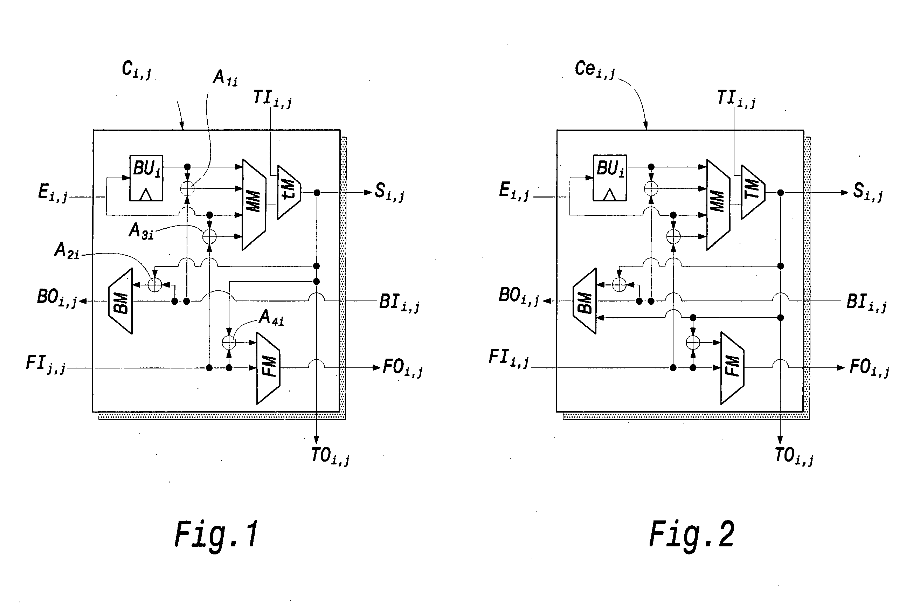

Figure 1 shows a hardware specific cell $C_{ij}$ that can be used to realize an integrated circuit which can be configured to perform the following operations:

- CRC generation that complies with anyone of the following standards: GSM (Global System for Mobile Communication), UMTS (Universal Mobile Telecommunication System), DMB (Digital Multimedia Broadcasting), DAB (Digital Audio Broadcasting), CDMA 2000 (Code Division Multiple Access 2000), WPAN (Wireless Personal Area Network), WLAN (Wireless Local Area Network), WMAN (Wireless Metropolitan Area Network),
- Convolutional encoding operations that comply with any one of the following standards: GSM, UMTS, DMB, CDMA 2000, iDEN (Integrated Digital Enhanced Network), PHS (Personal Handy-phone System), PDC (Personal Digital Cellular), WPAN, WLAN, WMAN, DVB (Digital Video Broadcasting), and
- Turbo encoding operations that comply with any one of the following standards: UMTS,. SDMB (Satellite Digital Multimedia Broadcasting), CDMA 2000, WMAN, and
- Randomization and scrambling operations that comply with any one of the following standards: UMTS, CDMA 2000, WMAN, WLAN, DMB, DAB, DVB.

The integrated circuit can also run chips spreading process.
Cell $C_{i,j}$ includes:

- four binary inputs $E_{ij}$, $FI_{ij}$, $BI_{ij}$ and $TI_{ij}$,
- four binary outputs $S_{ij}$, $FO_{ij}$, $BO_{ij}$, $TO_{ij}$,
- one buffer $BU_i$ directly connected to input $E_{ij}$ and that outputs a value E*,
- four adders $A_{1i}$, $A_{2i}$, $A_{3i}$ and $A_{4i}$, and
- four multiplexers MM, TM, BM and FM.

Buffer $BU_i$ is able to delay the binary value received on input $E_{ij}$ by one clock period to output a binary value E*. The output of buffer $BU_i$ is directly connected to a first input of multiplexer MM and to a first input of adder $A_{1i}$. A second input of adder $A_{1i}$ is directly connected to input $BI_{ij}$. The output of adder $A_{1i}$ is directly connected to a second input of multiplexer MM. Adder $A_{1i}$ provides on its output the result of an XOR operation between its inputs.
Input $E_{ij}$ is directly connected to a third input of multiplexer MM and to a first input of adder $A_{3i}$. A second input of adder $A_{3i}$ is directly connected to input $FI_{ij}$. The output of adder $A_{3i}$ is directly connected to a fourth input of multiplexer MM.

Multiplexer MM has an output connected to a first input of multiplexer TM. Multiplexer MM is able to directly connect any one of its inputs to the output depending on a configuration bit value stored in a cell configuration bit register. Thus, once a selected input is connected to the output, the multiplexer behave like if the selected input was directly wired to the output. This is also true for any of the multiplexers used in cell $E_{ij}$.

A second input of multiplexer TM is directly connected to input $T_{ij}$. The output of multiplexer TM is directly connected to output $S_{ij}$.

The output of multiplexer BM is directly connected to output $BO_{ij}$. A first and a second input of multiplexer BM are directly connected to input $BI_{ij}$ and an output of adder $A_{2i}$, respectively.

Adder $A_{2i}$ has a first and a second input directly connected to the output of multiplexer TM and to input $BI_{ij}$, respectively.

An output of multiplexer FM is directly connected to output $FO_{ij}$. Multiplexer FM has a first and a second input directly connected to input $FI_{ij}$ and to an output of adder $A_{4i}$, respectively.

Adder $A_{4i}$ has a first and second input directly connected to the output of multiplexer TM and to input $FI_{ij}$, respectively.

Output $TO_{ij}$ is directly connected at the output of multiplexer TM. Accordingly, cell $C_{ij}$ has the following characteristic equations:

$$TO_{ij} = S_{ij} = Ctm.TI_{ij} + !Ctm.OutputMux4 \tag{1}$$

$$OutputMux4 = Cmm0 . Cmm1 . E^* + !Cmm0 . Cmm1 . (E.^* \text{ XOR } BI_{ij}) + \tag{2}$$
$$Cmm0 . !Cmm1 . E_{ij} + !Cmm0 . !Cmm1 . (E_{ij} \text{ XOR } FI_{ij})$$

$$BO_{ij} = Cbm . (S_{ij} \text{ XOR } BI_{ij}) + !Cbm . BI_{ij} \tag{3}$$

$$FO_{ij} = Cfm . (S_{ij} \text{ XOR } FI_{ij}) + !Cfm . FI_{ij} \tag{4}$$

where:

- symbol "!" corresponds to the NOT operation
- symbol "*" refers to the output of buffer $BU_i$,
- symbol "XOR" corresponds to the XOR operation,
- symbol "+" corresponds to the OR operation,
- symbol "." corresponds to the AND operation,
- Cmm0 and Cmm1 are binary values that depend on the configuration of multiplexer MM,
- Ctm, Cbm and Cfm are binary values that depend on the configuration of multiplexer TM, BM and FM, respectively.

More precisely, the value of binary values Cmm0 and Cmm1 are defined by the following table where the first column recites which input is directly connected to the output of multiplexer MM and the second and third columns recite the values of Cmm0 and Cmm1, respectively.

Table 1

| Input | Cmm0 | Cmm1 |
|-------|------|------|
| E* | 1 | 1 |
| 2nd Input | 1 | 0 |
| 3rd Input | 0 | 1 |
| 4th Input | 0 | 0 |

Ctm is equal to "1" when multiplexer TM is configured to directly connect input $TI_{ij}$ to output $S_{ij}$ and equal to "0" when multiplexer TM is configured to directly connect the output of multiplexer MM to output $S_{ij}$.

Cbm is equal to "1" when multiplexer BM is configured to directly connect the output of adder $A_{2i}$ to output $BO_{ij}$. Otherwise, Cbm is equal to "0" when multiplexer BM is configured to directly connect input $BI_{ij}$ to output $BO_{ij}$.

Cfm is equal to "1" when multiplexer FM is configured to directly connect the output of adder $A_{4i}$ to output $FO_{ij}$. Otherwise, Cfm is equal to "0" when multiplexer FM is configured to directly connect input $FI_{ij}$ to output $FO_{ij}$.

Figure 2 shows a specific hardware cell $Ce_{i,j}$ which is identical to cell $C_{i,j}$ except that multiplexer BM has a third input directly connected to output $TO_{ij}$ and $S_{ij}$. Accordingly, the characteristic equations of cell $Ce_{ij}$ are identical to equations (1) to (4) except that equation (3) is replaced by the following characteristic equation:

$$BO_{ij} =$$

$$Cbm0 \cdot Cbm1 \cdot (S_{ij}\ XOR\ BI_{ij}) + !Cbm0 \cdot Cbm1 \cdot BI_{ij} + !Cbm0 \cdot Cbm1 \cdot S_{ij} \qquad (5)$$

where Cbm0 and Cbm1 are binary values which depend on the configuration of multiplexer BM.

More precisely, the values of Cbm0 and Cbm1 are defined according to the following table where the first column recites which input of multiplexer BM is directly connected to output $BO_{ij}$, and the second and third columns recite the corresponding value of Cbm0 and Cbm1.

Table 2

|  | Cbm0 | Cbm1 |
|---|---|---|
| 1st input | 1 | 1 |
| $BI_{ij}$ | 1 | 0 |
| $S_{ij}$ | 0 | 1 |

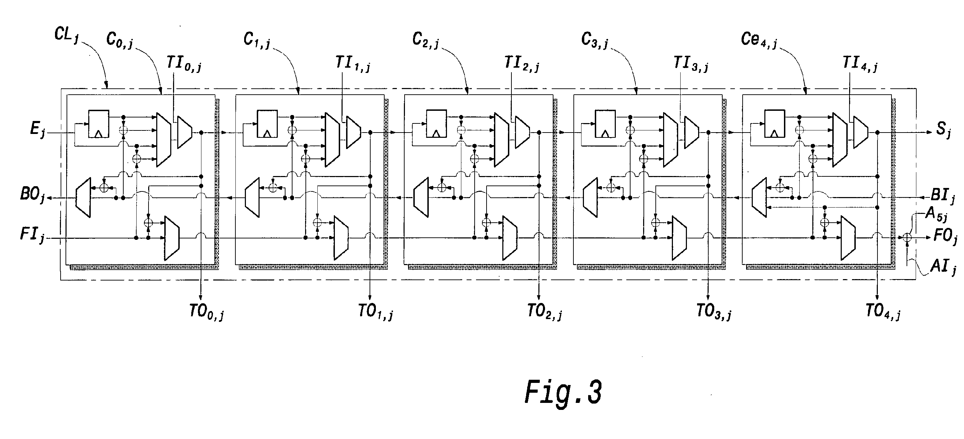

Figure 3 shows a cluster $CL_j$ which is formed by the connection in series of five cells $C_{0,j}$, $C_{1,j}$, $C_{2,j}$, $C_{3,j}$ and $Ce_{4,j}$. In the following specification, the first index "i" of the cell name $C_{i,j}$ indicates the position of the cell within a cluster and index "j" indicates the cluster in which is situated the cell $C_{ij}$ or $Ce_{ij}$.

Cluster $CL_j$ has four inputs $E_j$, $FI_j$, $BI_j$ and $AI_j$ as well as three outputs $S_j$, $FO_j$, and $BO_j$.

Inputs $E_j$ and $FI_j$ and output $BO_j$ are directly connected to input $E_{0j}$, $FI_{0j}$ and output $BO_{0j}$ of cell $C_{0,j}$, respectively. Outputs $S_j$, and input $BI_j$ are directly connected to outputs $S_{4j}$, and input $BI_{4j}$ of cell $Ce_{4,j}$, respectively.

Each cluster $CL_j$ includes an additional adder $A_{5J}$ which has a first and a second inputs directly connected to output $FO_{4,j}$ and input $AI_J$, respectively. The output of adder $A_{5J}$ is directly connected to output $FO_J$ of cluster $CL_J$.

Within a cluster, except for the last cell $Ce_{4,j}$, each cell $CI_{ij}$ is directly connected to the following cell $C_{i+1j}$ in the following way:

- outputs $S_{ij}$ and $FO_{ij}$ are directly connected to inputs $E_{i+1,j}$ and $FI_{i+1,j}$ of the following cell $C_{i+1,j}$ , and
- input $BI_{ij}$ is directly connected to output $BO_{i+1,j}$ of the following cell $C_{i+1,j}$.

The above connections between cells within a cluster are etched within the die of the integrated circuit. Thus, they cannot be modified or configured latter on.

Cluster $CL_j$ has also five inputs $TI_{i,j}$ which are directly connected to the respective corresponding input $TI_{i,j}$ of the corresponding cells. Cluster $CL_j$ has also five outputs $TO_{i,j}$ which are directly connected to the respective corresponding output $TO_{i,j}$ of the corresponding cell.

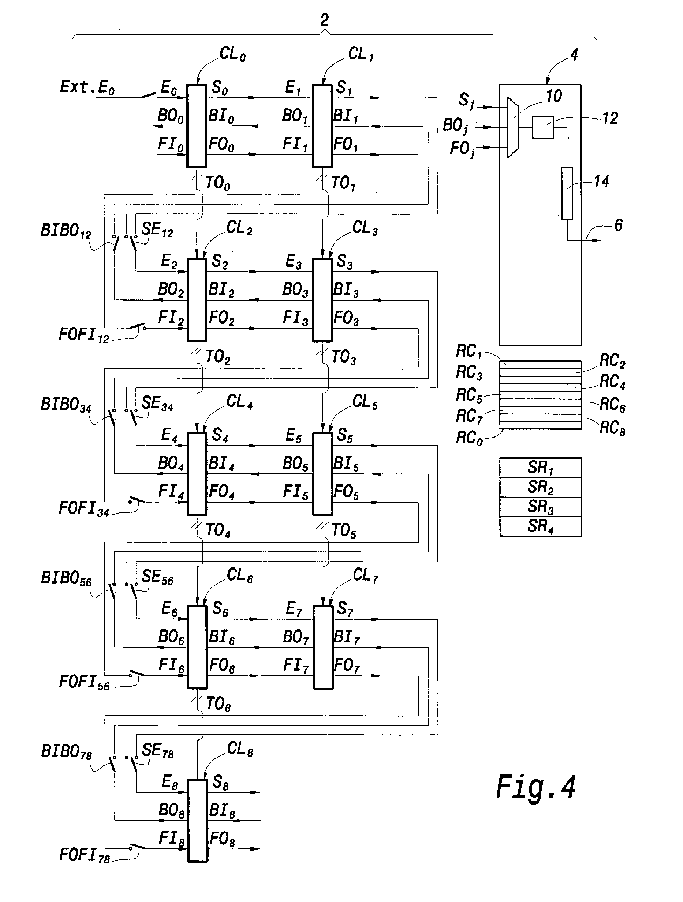

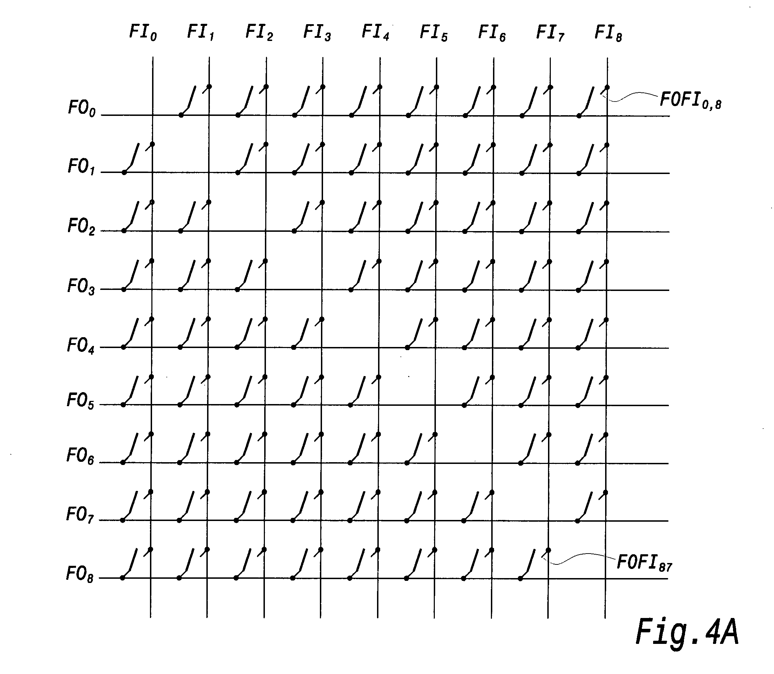

Figure 4 shows some parts of an integrated circuit 2 which is etched on the die of a chip.

Circuit 2 includes nine clusters $CL_0$ to $CL_8$ which are arranged on the surface of the die to form two columns and five rows. More precisely, clusters $CL_0$, $CL_2$, $CL_4$, $CL_6$ and $CL_8$ form the first column whereas clusters $CL_1$, $CL_3$, $CL_5$ and $CL_7$ form the second column.

The inputs and outputs of each cluster are connected to each other through configurable connections. The connections between clusters can be configured through the use of switch matrices. For example, circuit 2 includes five switch matrices.

A first switch matrix SE can electrically connect and, alternately, disconnect input $E_j$ to/from any output $S_k$ where "k" is different from "j" or, alternately, to an external binary source $ExtE_i$.

A second switch matrix FOFI can electrically connect and, alternately, disconnect output $FO_j$ to/from any input $FI_k$, where "k" is different from "j".

A third matrix BIBO can electrically connect and, alternately disconnect any input $BI_j$ to/from any output $BO_k$,

where "k" is different from "j".

A fourth switch matrix BOAI can electrically connect and, alternately, disconnect input $AI_j$ to any outputs $BO_k$ where "k" is different from "j".

In circuit 2, when an input of a cluster is not connected to an output of another cluster, this input is electrically connected to ground that corresponds to a binary value equal to "0".

Figure 4A shows switch matrix FOFI. Matrix FOFI is built from a great number of individual switches $FOFI_{nm}$. Each switch $FOFI_{nm}$ can electrically connect respective output $FO_n$ to a respective input $FI_m$ and, alternatively, electrically disconnect this output $FO_n$ from input $FI_m$. The matrix can be configured to make a one-to-one connection between an input and output or a one-to-many connections between output $FO_n$ and inputs FI. Typically, the switch matrix is realized using multiplexers.

In Figure 4A, a vertical line is only electrically connected to a horizontal line if the corresponding switch $FOFI_{nm}$ is conducting.

Matrices SE, BIBO and BOAI are built in a similar way as the one illustrated in Figure 4A.

For simplicity, in circuit 2, connections between two clusters on the same line are not configurable. For example, these connections are not implemented through a switch matrix. For example, outputs $S_0$, $FO_0$ and input $BI_0$ are directly connected to inputs $E_1$, $FI_1$ and output $BO_1$, without any configuration possibility.

For simplicity, only some switches of the switch matrices have been illustrated in Figure 4.

More precisely, Figure 4 shows four switches $SE_{12}$, $SE_{34}$, $SE_{56}$, $SE_{78}$ connected between output $S_j$ of the last cluster of the previous row and input $E_{j+1}$ of the first cluster of the following row.

Figure 4 shows also four switches $BIBO_{12}$, $BIBO_{34}$, $BIBO_{56}$, $BIBO_{78}$ connected between input $BI_j$ of the last cluster of the previous row and input $BO_{j+1}$ of the first cluster of the following row.

Finally, Figure 4 shows four switches $FOFI_{12}$, $FOFI_{34}$, $FOFI_{56}$, and $FOFI_{78}$ connected between the output of adder $A_{5j}$ and input $FI_{j+1}$.

Switches of BOAI matrix have not being shown.

In circuit 2, outputs $TO_{ij}$ of cluster $CL_j$ are only connected to corresponding respective inputs $TI_{i,j+2}$ of the following cluster $CL_{j+2}$ in the same column.

Circuit 2 has also nine cluster configuration registers $RC_j$. Each cluster configuration register $RC_j$ contains the value of Ctm, Cmm0, Cmm1, Cbm and Cfm that determine the configuration of each cell $C_{i,j}$ of cluster $CL_j$ as well as the value of Ctm, Cmm0, Cmm1, Cbm0, Cbm1 and Cfm that determine the configuration of cell $Ce_{i,j}$ of cluster $CL_j$. Thus, the configuration of each cell of each cluster can be amended by modifying the values stored in each one of these registers $CR_j$.

Circuit 2 has also four switch matrix configuration registers $SR_1$ to $SR_4$. These registers determine the configuration of the connections between the different clusters $CL_j$ of circuit 2. More precisely, each register SR contains binary information that determines if a given switch of the switch matrix is open or closed. Accordingly, those registers are used to configure the connections between clusters.

Circuit 2 has also an output stage 4 which is connected to every outputs of every cluster. Output stage 4 is designed to format the output of clusters $CL_j$ in order to transmit the result of the computation of circuit 2 on a eight-bit width parallel bus 6. For example, output stage 4 includes a multiplexer 10 that is connected to every outputs of each cluster. Nine outputs of multiplexer 10 are connected to respective inputs of a packager 12. Packager 12 is able to output the received bits one after the other in a FIFO (First In First Out) buffer 14 which can send the received data on bus 6.

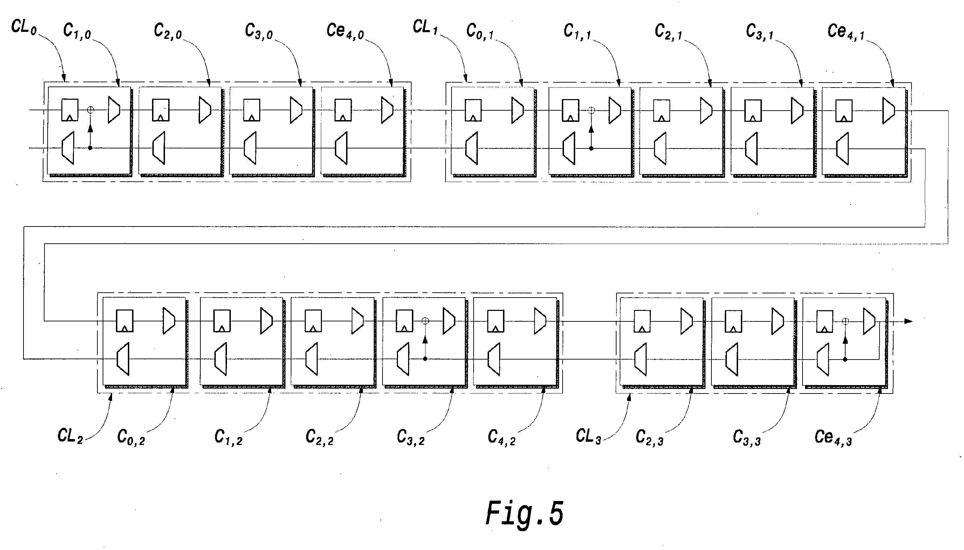

Figure 5 shows the configuration of circuit 2 to compute a CRC code as specified in standard WLAN or standard 802.11. More precisely, the configuration shown in Figure 5 implements the generation and the check sequence of a CCITT CRC-16 bit generated with the following polynomial: $x^{16} + x^{12} + x^{5+1}$.

As show in this configuration example, only four cells $C_{1,0}$ to $Cue_{4,0}$ of cluster $CL_0$ are used. In order to bypass cell $C_{0,0}$, multiplexers MM and TM are configured to directly connect input $E_{0,0}$ to output $S_{0,0}$. Thus, any cell within a cluster can be bypassed.

To implement the terms $x^{16} + x^{12} + x^{5+1}$ of the above polynomial, the multiplexers MM and TM of cells $C_{1,0}$, $C_{1,1}$, $C_{3,2}$ and $Ce_{4,3}$ are configured to directly connect the output of adder $A_{1i}$ to output $S_3$. The other cells which are not bypassed are only configured to implement a delay of one clock period.

In this configuration, the clusters $CL_0$ to $CL_3$ are series connected. More precisely, output $S_j$ is connected to input $E_{j+1}$ of the following cluster and input $BI_j$ is directly connected to output $BO_{j+1}$ of the following cluster $CL_{j+1}$.

In this embodiment, only four clusters are used.

In this configuration the data are input through input $E_0$ and the CRC code is read from output $S_3$.

Note that cell $Cue_{4,3}$ is configured so that output $S_3$ is directly connected to output $BO_{43}$ through multiplexer BM. Thus, multiplexer BM provides the source of the feedback branch.

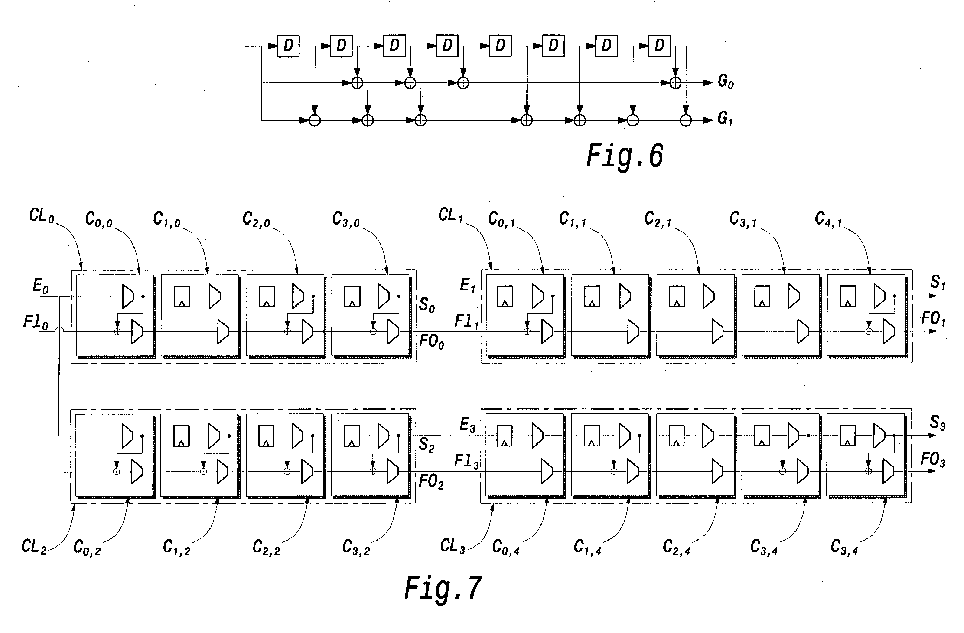

Figure 6 shows a convolutional encoder with a rate of 1/2 which complies with UMTS standards. Cells D represent delay line of one clock period. This convolutional encoder is a well-known encoder that will not be described in further details. The results of the convolutional encoder are output through pins Go and $G_1$.

Figure 7 shows the configuration of circuit 2 to implement the convolutional encoder of Figure 6. Only four clusters $CL_0$ to $CL_3$ are used. Outputs $S_0$ and $FO_0$ are directly connected to inputs $E_1$ and $FI_1$. Similarly, outputs $S_2$ and $FO_2$ are directly connected to inputs $E_3$ and $FI_3$, respectively.

Inputs $E_0$ and $E_2$ receive the binary stream to be encoded.

Outputs $FO_1$ and $FO_3$ correspond to outputs $G_0$ and $G_1$ of Figure 6.

Outputs $S_1$ and $S_3$ are not used. In the configuration of Figure 7, cell $Ce_{4,0}$ and $Ce_{4,2}$ are bypassed. Switches $SE_{01}$ and $SE_{23}$ are conducting. Switches $FOFI_{01}$ and $FOFI_{23}$ are also conducting. Every other switch of the matrices is nonconducting. Adders $A_{5j}$ are not used.

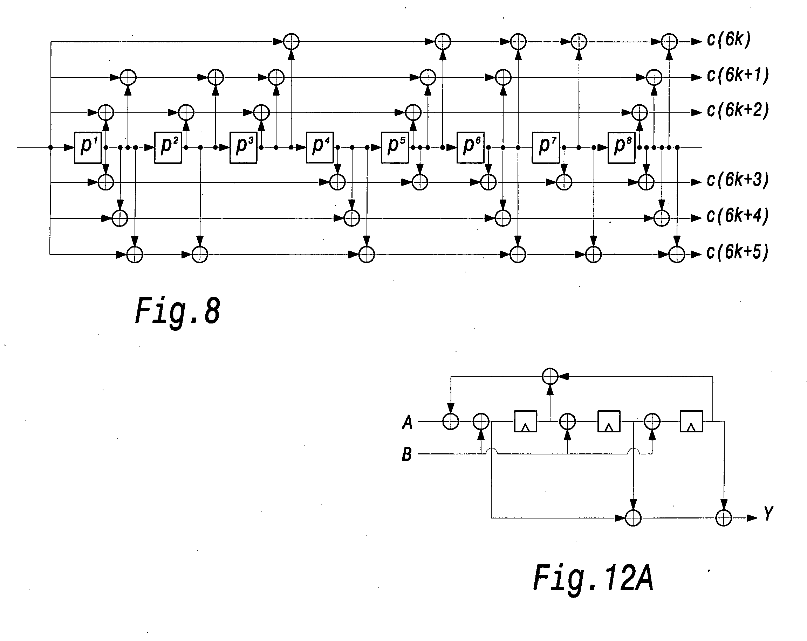

Figure 8 shows a convolutional encoder having a rate of 1/6. This convolutional encoder is defined in the standards concerning CDMA 2000. It will thus not be described in further details. Cells $P^i$ are delay lines of one clock period. The result of the convolution is output through outputs c(6k), c(6k+1), c(6k+2), c(6k+3), c(6k+4) and c(6k+5).

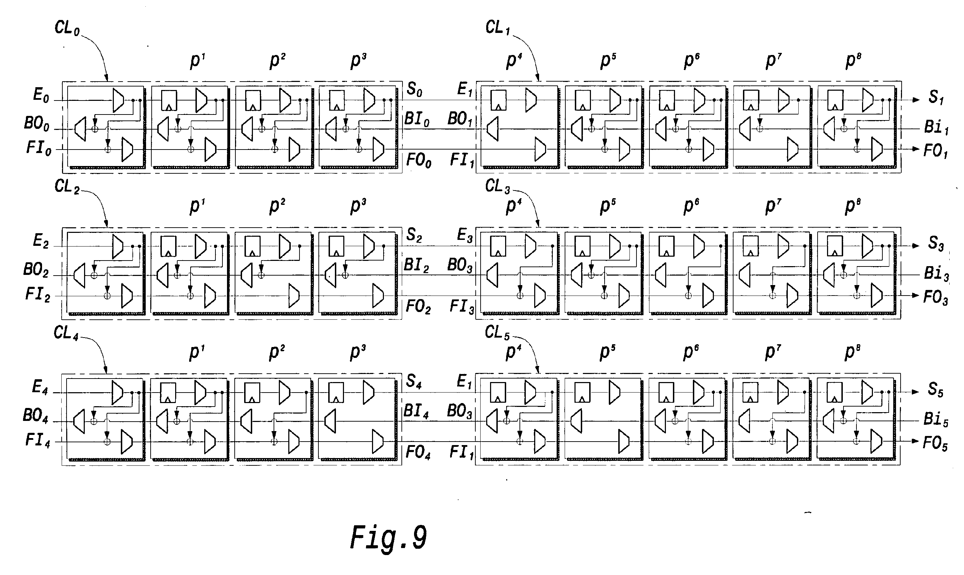

Figure 9 illustrates the configuration of circuit 2 to implement the convolutional encoder of Figure 8. This implementation only needs six clusters $CL_0$ to $CL_5$.

In this configuration, cells $Ce_{4,0}$, $Ce_{4,2}$ and $Ce_{4,4}$ are bypassed.

Inputs $E_0$, $E_2$ and $E_4$ receive the same binary input stream.

Outputs $FO_1$, $FO_3$ and $FO_5$ correspond to outputs c(6k +1), c(6k + 3) and c(6k + 5) of the convolutional encoder of Figure 8, respectively.

Outputs $BO_0$, $BO_2$ and $BO_4$ correspond to outputs c(6k), c(6k + 2), c(6k + 4) of the convolutional encoder of Figure 8, respectively.

Outputs $S_1$, $S_3$ and $S_5$ are not used.

Inputs $FI_0$, $FI_2$ and $FI_4$ and inputs $BI_1$, $BI_3$ and $BI_5$ are connected to ground.

In this configuration, it should be noted that outputs c(6k), c(6k + 2), c(6k + 4) are computed by using feedback branches of the clusters whereas output c(6k +1), c(6k + 3) and c(6k + 5) are computed by using forward branches of the same clusters. Thus, only six clusters are needed instead of twelve clusters if only forward branches were used.

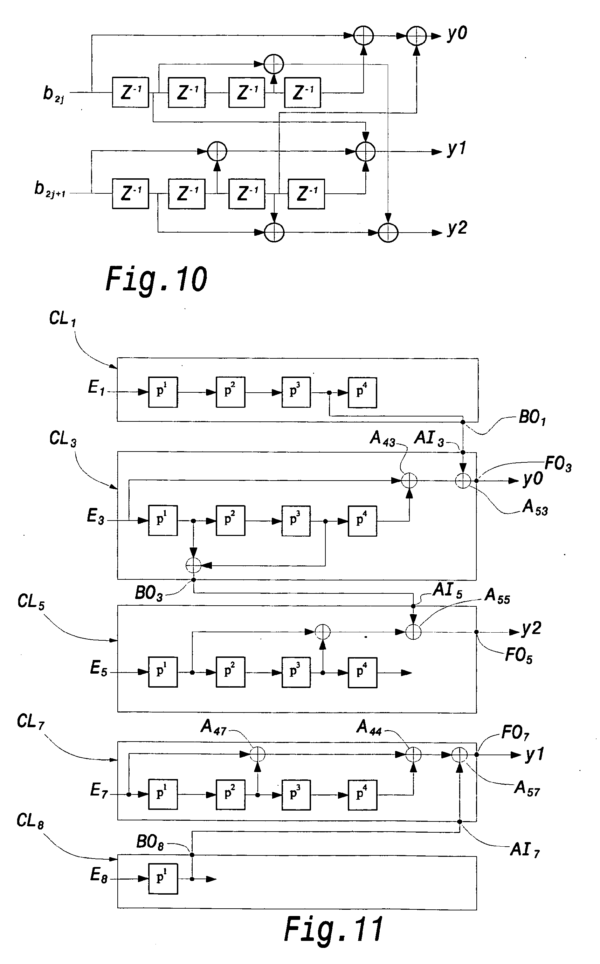

Figure 10 shows a convolutional encoder with interbranch connections. The illustrated convolutional encoder is described in more details in the standard WLAN 802.11g or DSSS 22 and 33 Mbit/s. Cells with symbol $Z^{-1}$ are delay lines of one clock period. This encoder receives input signal $b_{2j}$ and $b_{2j+1}$ and outputs three binary streams $y_0$, $y_1$ and $y_2$.

An interbranch connection is a connection through a adder between two different forward branches, for example.

Figure 11 shows the configuration of circuit 2 to implement the convolutional encoder of Figure 10. In this configuration, only clusters $CL_1$, $CL_3$, $CL_5$, $CL_7$ and $CL_8$ are used. The cells of clusters $CL_0$, $CL_2$, $CL_4$ and $CL_6$ are bypassed.

In this embodiment, the switch matrix BOAI is used to connect output $BO_1$, to input $AI_3$, output $BO_3$ to input $AI_5$ and output $BO_8$ to input $AI_7$.

Inputs $E_3$, $E_8$ receive binary stream $b_{2j}$. Inputs $E_1$, $E_5$, and $E_7$ receive binary stream $b_{2j+1}$.

Binary stream $y_0$, $y_1$ and $y_2$ correspond to outputs $FO_3$, $FO_7$ and $FO_5$, respectively.

Figure 12A shows a turbo-coder which complies with the following transmission technology:

- WMAN-SCa,
- WMAN-OFDM,
- WMAN-OFDMA.

This turbo-coder is well known and will not be described in further details hereinafter. This turbo-coder has two inputs A and B and one output Y.

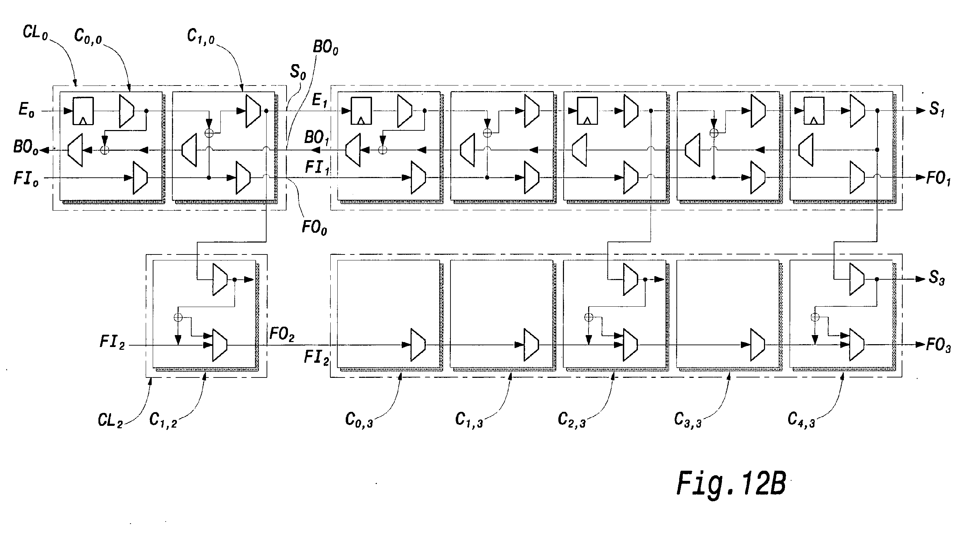

Figure 12B shows the configuration of circuit 2 to implement the turbo-coder of Figure 12A. In the illustrated configuration, it has been assumed that circuit 2 has simplified switch matrices which does not allow to configure the connections between two successive clusters in the same row.

As illustrated in Figure 12B, the simplification of the switch matrix does not prevent from configuring circuit 2 to implement the turbo-coder of Figure 12A.

In this configuration, inputs $E_0$ and $FI_0$ correspond to inputs A and B of Figure 12A. Outputs $FO_3$ corresponds to output Y of Figure 12A.

Outputs $BO_0$, $S_1$, $FO_1$, $S_3$ are not used.

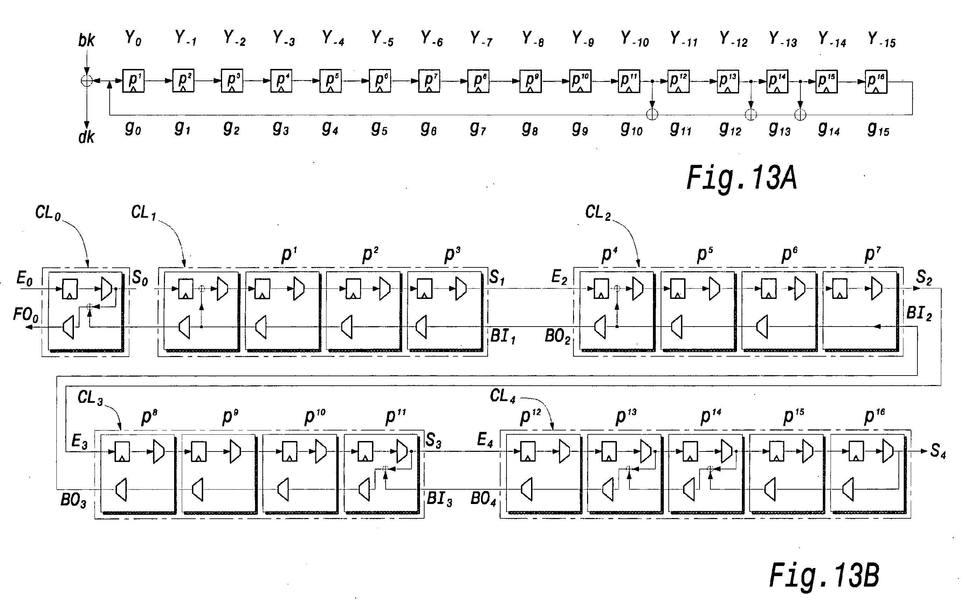

Figure 13A shows a scrambler which is defined in the UMTS standards for HS-DSCH or commonly called HSDPA (High Speed Downlink Packet Access). Thus, this scrambler will not be described in further details. It has a bit stream input $b_R$ and a bit stream output $d_k$. Cells with symbol $p^i$ are delay lines of one clock period.

Figure 13B shows the configuration of circuit 2 to implement the scrambler of Figure 13A.

Only five clusters $CL_0$ to $CL_4$ are used. Input $E_0$ receives the bit stream $b_k$. Output $FO_0$ outputs the bit stream corresponding to bit stream $d_k$ of Figure 13A. Output $S_0$ and $S_4$ are not used.

Many other embodiments are possible. For example, inputs $TI_{ij}$ and outputs $TO_{ij}$ can be omitted if coding schemes requiring such transversal connections are not required. In another embodiment, adder $A_{5j}$ can also be omitted.

Circuit 2 has been disclosed in the specific case where it comprises nine clusters of five cells. However, such an integrated circuit can also be built using only five to ten clusters. This range of number of clusters corresponds to configurations which are both flexible and fast in executing any calculation of code.

The size of the switch matrices can be reduced if cluster $CL_j$ can only be connected to the following cluster $CL_{j+1}$. This also reduces the size of the corresponding configuration registers $SR_1$ to $SR_4$. It is also possible to reduce the size of the switch matrices by having only one output to be connected to only one input of another cluster.

Cell $Ce_{i,j}$ can be omitted if it is not necessary to implement the generation of CRC codes.

The additional adders $A_{5j}$ connected between outputs $FO_{4j}$ and output $FO_j$ can be replaced by an adder connected between output $S_{4j}$ and output $S_j$.

In the present specification and claims the word "a" or "an" preceding an element does not exclude the presence of a plurality of such elements. Further, the word "comprising" does not exclude the presence of other elements or steps than those listed.

The inclusion of reference signs in parentheses in the claims is intended to aid understanding and is not intended to be limiting.

From reading the present disclosure, other modifications will be apparent to persons skilled in the art. Such modifications may involve other features which are already known in the art of encoding data and which may be used instead of or in addition to features already described herein.

**Claims**

1. Integrated circuit configurable to encode data according to any one of the coding schemes chosen in a predetermined plurality of coding schemes and to generate cyclic redundancy codes, said predetermined plurality of coding schemes comprising block, convolutional and turbo codes, wherein the integrated circuit comprises:

   a) a plurality of specific hardware cells, each cell comprising:

   - outputs $S_{ij}$, $FO_{ij}$, $BO_{ij}$ and $TO_{ij}$ for binary signals,
   - inputs $E_{ij}$, $BI_{ij}$, $FI_{ij}$ and $TI_{ij}$ for binary signals,
   - a buffer to delay by one clock period a binary value received on input $E_{ij}$ and to output a one-clock period delayed binary value $E^*$,
   - binary adders to perform XOR operations,
   - configurable multiplexers connecting the outputs, the inputs, the buffer and the adders to each other according to several configurable paths, the characteristic equations of the cell being:

   •

$$TO_{ij} = S_{ij} = Ctm.TI_{ij} + !Ctm.\, OutputMux4$$

   •

$$OutputMux4 =$$
$$Cmm0 . Cmm1 . E^* + !Cmm0 . Cmm1 . (E^* \text{ XOR } BI_{ij}) +$$
$$Cmm0 . !Cmm1 . E + !Cmm0 . !Cmm1 . (E_{ij} \text{ XOR } FI_{ij})$$

   •

$$BO_{ij} = Cbm . (S_{ij} \text{ XOR } BI_{ij}) + !Cbm . BI_{ij}$$

   or

$$BO_{ij} = Cbm0 . Cbm1 . (S_{ij} \text{ XOR } BI_{ij}) + !Cbm0 . Cbm1 . BI_{ij} + !Cbm0 . Cbm1 . S_{ij}$$

.

$$FO_{ij} = Cfm . (S_{ij} \text{ XOR } FI_{ij}) + !Cfm . FI_{ij}$$

where:

- $S_{ij}$, $FO_{ij}$, $BO_{ij}$ and $TO_{ij}$ are the binary signals output on outputs $S_{ij}$, $FO_{ij}$, $BO_{ij}$ and $TO_{ij}$, respectively,
- $E_{ij}$, $BI_{ij}$, $FI_{ij}$ and $TI_{ij}$ are the binary signals received on inputs $E_{ij}$, $BI_{ij}$, $FI_{ij}$ and $TI_{ij}$, respectively,
- "I" is the NOT operation,
- "*" is the output of the buffer,
- "XOR" is the XOR operation,
- "+" is the OR operation,
- "." is the AND operation,
- Cbm, Cbm0, Cbm1, Cfm, Cmm0 Cmm1 and Ctm are respective binary values that represent the configuration of each multiplexer,

b) controllable switch matrices external to each cell and able:

- to electrically connect and, alternatively, to electrically disconnect input $E_{ij}$ to/from at least the output $S_{ij}$ of another cell and to electrically connect and, alternately, to electrically disconnect Input $E_{ij}$ to/from an external binary data source,
- to electrically connect and, alternately, to electrically disconnect at least input $FI_{ij}$ to/from at least the output $FO_{ij}$ of another cell,
- to connect and, alternately, to disconnect input $BI_{ij}$ to/from at least the output $Bo_{ij}$ of another cell.

2. The circuit according to claim 1, wherein the integrated circuit comprises a plurality of clusters $CL_j$, each cluster $CL_j$ comprising:

- inputs $E_j$, $FI_j$ and $BI_j$,
- outputs $S_j$, $BO_j$ and $FO_j$,
- a succession of at least two cells $C_{ij}$ successively electrically connected to each other, the first cell of the succession having its inputs $E_{ij}$ and $FI_{ij}$ and its output $BO_{ij}$ directly connected to inputs $E_j$, $FI_j$ and output $BO_j$ without configuration possibility, respectively,
the last cell of the succession having its input $BI_{ij}$ and its outputs $S_{ij}$ and $FO_{ij}$ connected, without configuration possibility to input $BI_j$, outputs $S_j$ and $FO_j$, respectively, and
any cell other than the last cell having its input $BI_{ij}$ and its outputs $S_{ij}$ and $FO_{ij}$ connected, without any configuration possibility, to output $BO_{ij}$ and inputs $E_{ij}$ and $FI_{ij}$ of the following cell of the succession, respectively, and

wherein the switch matrix is only able to configure the electrical connections between cluster inputs and outputs without being able to configure the electrical connections between cells within a cluster.

3. The integrated circuit according to claim 2, wherein the outputs $S_j$, $FO_i$ and the input $BI_j$ of at least one cluster are connected to inputs $E_j$, $FI_j$ and output $BO_j$ of another cluster without configuration possibility, respectively.

4. The integrated circuit according to claim 2 or 3, wherein the integrated circuit comprises between five to ten clusters and each cluster is composed of five cells.

5. The integrated circuit according to any one of claims 2 to 4, wherein each cluster has at least one cell having the following characteristic equation:

$$BO_{ij} = Cbm0 \cdot Cbm1 \cdot (S_{ij} \text{ XOR } BI_{ij}) + !Cbm0 \cdot Cbm1 \cdot BI_{ij} + !Cbm0 \cdot Cbm1 \cdot S_{ij}$$

6. The integrated circuit according to claims 1 and 2, wherein the inputs $TI_{ij}$ of the succession of cells of a cluster, are directly connected to respective outputs $TO_{ij}$ of the succession of cells of another cluster without any configuration possibility.

7. The integrated circuit according to claims 2 to 5, wherein a cluster $CL_j$ comprises an input $AI_j$ and an adder having an first input directly connected to input $AI_j$, a second input and an output, the second input and the output of the adder being:

• either connected to output $FO_{ij}$ of the last cell and to output $FO_j$, respectively,
• or connected to output $S_{ij}$ of the last cell and to output $S_j$, respectively.

**Patentansprüche**

1. Integrierte Schaltung, die konfigurierbar ist, um Daten gemäß einem beliebigen der Kodierschemen zu kodieren, das aus einer vorgegebenen Mehrzahl von Kodierschemen ausgewählt ist, und um zyklische Redundanzkodes zu erzeugen, besagte vorgegebene Mehrzahl von Kodierschemen Block-, Konvolutional- und Turbokodes aufweist, wobei die integrierte Schaltung aufweist:

a) eine Mehrzahl von spezifischer Hardwarezellen, wobei jede Zelle aufweist:

• Ausgänge $S_{ij}$, $FO_{ij}$, $BO_{ij}$ und $TO_{ij}$ für binäre Signale,
• Eingänge $E_{ij}$ $FI_{ij}$, $BI_{ij}$ und $TI_{ij}$ für binäre Signale,
• einen Puffer, um einen binären Wert, der am Eingang $E_{ij}$ empfangen wurde um eine Taktperiode zu verzögern, und um einen um eine Taktperiode verzögerten binären Wert E* auszugeben,
• binäre Addierer, um XOR-Operationen durchzuführen,
• konfigurierbare Multiplexer, welche die Ausgänge, die Eingänge, die Puffer und die Addierer miteinander gemäß verschiedener konfigurierbarer Wege verbinden, wobei die charakteristischen Gleichungen der Zelle sind:

•

$$TO_{ij} = S_{ij} = Ctm.TI_{ij} + !Ctm.OutputMux4$$

•

$$OutputMux4 =$$
$$Cmm0 \cdot Cmm1 \cdot E^* + !Cmm0 \cdot Cmm1 \cdot (E^* \text{ XOR } BI_{ij}) +$$
$$Cmm0 \cdot !Cmm1 \cdot E + !Cmm0 \cdot !Cmm1 \cdot (E_{ij} \text{ XOR } FI_{ij})$$

•

$$BO_{ij} = Cbm \cdot (S_{ij} \text{ XOR } BI_{ij}) + !Cbm \cdot Cbm \cdot BI_{ij}$$

oder

$$BO_{ij} = Cbm0 \cdot Cbm1 \cdot (S_{ij} \text{ XOR } BI_{ij}) + !Cbm0 \cdot Cbm1 \cdot BI_{ij} +$$

$$!Cbm0 . Cbm1 . S_{ij}$$

$$\cdot$$

$$FO_{ij} = Cfm . (S_{ij} \; XOR \; FI_{ij}) \; + \; !Cfm . FI_{ij}$$

wobei:

- $S_{ij}$, $FO_{ij}$, $BO_{ij}$ and $TO_{ij}$ die binären Signalausgänge an den Ausgängen $S_{ij}$, $WO_{ij}$, $BO_{ij}$ bzw. $TO_{ij}$ sind,
- $E_{ij}$, $BI_{ij}$, $FI_{ij}$ und $TI_{ij}$ die binären Signale sind, die an den Eingängen $E_{ij}$, $BI_{ij}$, $FI_{ij}$ bzw. $TI_{ij}$, empfangen wurden,
"!" eine NICHT Operation ist,
- "*" die Ausgabe des Puffers ist,
- "XOR" die XOR-Operation ist,
- "+" die ODER-Operation ist,
- "." die UND-Operation ist,
- Cbm, CbmO, Cbm1, Cfm, Crnm0, Cmm1 und Ctm jeweils binäre Werte sind, welche die Konfiguration jedes Multiplexers wiedergeben,

b) Steuerbare Schaltmatrizen, die außerhalb jeder Zelle und dazu in der Lage sind:

- den Eingang $E_{ij}$ mit wenigstens dem Ausgang $S_{ij}$ einer anderen Zelle elektrisch zu verbinden und alternativ davon elektrisch zu trennen, und den Eingang $F_{ij}$, mit wenigstens einer externen binären Datenquelle elektrisch zu verbinden und alternativ davon elektrisch zu trennen,
- den Eingang $F_{ij}$ mit wenigstens dem Ausgang $FO_{ij}$ einer anderen Zelle elektrisch zu verbinden und alternativ davon elektrisch zu trennen,
- den Eingang $B_{ij}$ mit wenigstens dem Ausgang $BO_{ij}$ einer anderen Zelle zu verbinden und alternativ davon zu trennen.

2. Schaltung nach Anspruch 1, wobei die integrierte Schaltung eine Mehrzahl von Cluster $CL_j$ aufweist, wobei jeder Cluster $CL_j$ aufweist:

- Eingänge $E_j$, $FI_j$ und $BI_j$,
- Ausgänge $S_j$, $BO_j$ und $FO_j$,
- eine Reihe von wenigstens zwei Zellen $C_{ij}$, die aufeinanderfolgend elektrisch miteinander verbunden sind, wobei die erste Zelle der Reihe ihre Eingänge $E_{ij}$ und $FI_{ij}$ und ihren Ausgang $BO_{ij}$ jeweils direkt mit den Eingängen $E_j$, $FI_j$ und dem Ausgang $BO_j$ verbunden hat, ohne der Möglichkeit einer Konfiguration,
die letzte Zelle der Reihe ihren Eingang $BI_{ij}$ und ihre Ausgänge $S_{ij}$ und $FO_{ij}$ mit dem Eingang $BI_{ij}$ bzw. den Ausgängen $S_j$ und $FO_j$ verbunden hat, ohne der Möglichkeit einer Konfiguration, und
eine beliebige Zelle, die sich von der letzten Zelle unterscheidet, ihren Eingang $BI_y$ und ihre Ausgänge $S_{ij}$ und $FO_{ij}$ jeweils mit dem Ausgang $BO_{ij}$ und den Eingängen $E_{ij}$ und $FI_{ij}$ der folgenden Zelle der Reihe verbunden hat, ohne der Möglichkeit einer Konfiguration, und
wobei die Schaltmatrix nur dazu in der Lage ist, die elektrischen Verbindungen zwischen Cluster-Eingängen und -Ausgängen zu konfigurieren, ohne dazu in der Lage zu sein, die elektrischen Verbindungen zwischen den Zellen innerhalb eines Clusters zu konfigurieren.

3. Integrierte Schaltung nach Anspruch 2, wobei jeweils die Ausgänge Sj, FOj und der Eingang BIj wenigstens eines Clusters mit den Eingängen Ej, FIj und dem Ausgang BOj eines anderen Clusters verbunden sind, ohne der Möglichkeit einer Konfiguration.

4. Integrierte Schaltung nach Anspruch 2 oder 3, wobei die integrierte Schaltung zwischen fünf und zehn Cluster aufweist und jeder Cluster aus fünf Zellen besteht.

5. Integrierte Schaltung nach einem der Ansprüche 2 bis 4, wobei jeder Cluster wenigstens eine Zelle hat, welche die folgende charakteristische Gleichung erfüllt:

$$BO_{ij} = Cbm0 . Cbm1 . (S_{ij} \text{ XOR } BI_{ij}) + !Cbm0 . Cbm1 . BI_{ij} + !Cbm0 . Cbm1 . S_{ij}$$

**6.** Integrierte Schaltung nach Ansprüche 1 und 2, wobei die Eingänge $TI_{ij}$ der Reihe von Zellen eines Clusters direkt mit den jeweiligen Ausgängen $TO_{ij}$ der Reihe von Zellen eines anderen Clusters verbunden sind, ohne der Möglichkeit einer Konfiguration.

**7.** Integrierte Schaltung nach den Ansprüchen 2 bis 5, wobei ein Cluster $CL_j$ einen Eingang $AI_j$ und einen Addierer mit einem ersten Eingang, der direkt mit dem Eingang $AI_j$ verbunden ist, einen zweiten Eingang und einen Ausgang, aufweist, wobei der zweite Eingang und der Ausgang des Addierers sind:

- entweder verbunden mit dem Ausgang $FO_{ij}$ der letzten Zelle beziehungsweise dem Ausgang $FO_j$,
- oder mit dem Ausgang $S_{ij}$ der letzten Zelle beziehungsweise dem Ausgang $S_j$ verbunden ist

**Revendications**

**1.** Circuit intégré configurable pour l'encoder de données selon l'un quelconque des codes choisis au sein d' une pluralité de codes prédéterminés et pour la génération de codes cycliques de redondance, ladite pluralité de codes prédéterminés comportant des codes de bloc, de convolution et turbo, dans lequel le circuit intégré comporte :

a) une pluralité de cellules matérielles spécifiques, chaque cellule comportant:

- des sorties $S_{ij}$, $FO_{ij}$, $BO_{ij}$ et $TO_{ij}$ correspondant à des signaux binaires,
- des entrées $E_{ij}$, $BI_{ij}$, $FI_{ij}$ et $TI_{ij}$ correspondant à signaux binaires,
- une mémoire tampon afin de retarder d'une période d'horloge une valeur binaire reçue sur l'entrée $E_{ij}$ et de fournir en sortie une valeur binaire E* retardée d'une période d'horloge,
- des additionneurs binaires pour effectuer des opérations XOR,
- des multiplexeurs configurables connectant les sorties, les entrées, les mémoires tampons et les additionneurs les uns aux autres suivant plusieurs chemins configurables, les équations caractéristiques de la cellule étant:
- 

$$TO_{ij} = S_{ij} = Ctm.TI_{ij} + !Ctm . OutputMux4$$

- 

$$OutputMux4 =$$
$$Cmm0 . Cmm1 . E* + !Cmm0 . Cmm1 . (E* \text{ XOR } BI_{ij}) +$$
$$Cmm0 . !Cmm1 . E + !Cmm0 . !Cmm1 . (E_{ij} \text{ XOR } FI_{ij})$$

- 

$$BO_{ij} = Cbm . (S_{ij} \text{ XOR } BI_{ij}) + !Cbm . BI_{ij}$$

ou

$$BO_{ij} = Cbm0 . Cbm1 . (S_{ij} \text{ XOR } BI_{ij}) + !Cbm0 . Cbm1 . BI_{ij} +$$
$$!Cbm0 . Cbm1 . S_{ij}$$

-

$$FO_{ij} = Cfm \cdot (S_{ij} \text{ XOR } FI_{ij}) + !Cfm \cdot FI_{ij}$$

où:

- $S_{ij}$, $FO_{ij}$, $BO_{ij}$ and $TO_{ij}$ sont des sorties des signaux binaires sur les sorties $S_{ij}$, $FO_{ij}$, $BO_{ij}$, and $TO_{ij}$, respectivement
- $E_{ij}$, $BI_{ij}$, $FI_{ij}$ and $TI_{ij}$ sont les signaux binaires reçues sur les entrées $E_{ij}$, $BI_{ij}$, $FI_{ij}$ and $TI_{ij}$, respectivement,
- "!" est l'opération NOT
- "*" est la sortie de la mémoire tampon
- "XOR" est l' opération XOR,
- "+" est l'opération OR,
- "." est l' opération AND,
- Cbm, Cbm0, Cbm1, Cfm, Cmm0, Cmm1 and Ctm sont des valeurs binaires lesquelles respectivement représentes la configuration de chaque multiplexeur

b) des matrices de commutation externes à chaque cellule, commandables et capables :

- de connecter électriquement et, alternativement, de déconnecter électriquement l'entrée $E_{ij}$ à/de au moins la sortie $S_{ij}$ d'une autre cellule et pour connecter électriquement et, alternativement, de déconnecter électriquement l'entrée $E_{ij}$ à/depuis une source de données binaire externe,
- de connecter électriquement et, alternativement, de déconnecter électriquement au moins l'entrée $FI_{ij}$ à/depuis au moins la sortie $FO_{ij}$ d'une autre cellule,
- de connecter et, alternativement, de déconnecter l'entrée $BI_{ij}$ à/depuis au moins la sortie $BO_{ij}$ d'une autre cellule.

2. Le circuit selon la revendication 1, dans lequel le circuit intégré comporte une pluralité des groupes $CL_j$, chaque groupe $CL_j$ comportant :

- des entrées $E_j$, $FI_j$ et $BI_j$,
- des sorties $S_j$, $BO_j$ et $FO_j$,
- une succession d'au moins deux cellules $C_{ij}$ successivement électriquement connectées l'une à l'autre, la première cellule de la succession ayant ses entrées $E_{ij}$ et $FI_{ij}$ et sa sortie $BO_{ij}$ directement connectées aux entrées $E_j$, $FI_j$ et sortie $BO_j$ sans autre configuration, respectivement, la dernière cellule de la succession ayant son entrée $BI_{ij}$ et ses sorties $S_{ij}$ et $FO_{ij}$ connectées, sans possibilité de configuration pour entrée $BI_j$, sorties $S_j$ et $FO_j$, respectivement, et l'une quelconque de cellules autre que la dernière cellule ayant son entrée $BI_{ij}$ et ses sorties $S_{ij}$ et $FO_{ij}$ connectées, sans autre possibilité de configuration, pour produire sortie $BO_{ij}$ et entrées $E_{ij}$ et $FI_{ij}$ de la cellule de la succession suivante, respectivement, et

grâce auquel la matrice de commutation est capablement uniquement de configurer les connexions électriques entre des groupes des entrées et sorties sans pouvoir configurer les connexions électriques entre les cellules au sein d' une groupe.

3. Le circuit intégré selon la revendication 2, dans lequel les sorties $S_j$, $FO_j$ et l'entrée $BI_j$ d' au moins une groupe sont connectées aux entrées $E_j$, $FI_j$ et à la sortie BOj d'un autre groupe sans possibilité de configuration, respectivement.

4. Le circuit intégré selon les revendication 2 ou 3, dans lequel le circuit intégré comporte entre cinq et dix groupes et chaque groupe se compose de cinq cellules.

5. Le circuit intégré selon l'une quelconque des revendications 2 à 4, dans lequel chaque groupe a au moins une cellule ayant l'équation caractéristique suivante :

$$BO_{ij} = Cbm0 \cdot Cbm1 \cdot (S_{ij} \text{ XOR } BI_{ij}) + ! Cbm0 \cdot Cbm1 \cdot BI_{ij} + !Cbm0 \cdot Cbm1 \cdot S_{ij}.$$

**6.** Le circuit intégré selon les revendications 1 et 2, dans lequel les entrées $TI_{ij}$ de la succession des cellules d'un groupe, sont directement reliés aux sorties respectives $TO_{ij}$ de la succession des cellules d'un autre groupe sans autre possibilité de configuration.

**7.** Le circuit intégré selon les revendications 2 à 5, dans lequel un groupe $CL_j$ comporte une entrée $AI_j$ et un additionneur ayant une première entrée connectée directement à l'entrée $AI_j$, une deuxième entrée et une sortie, la deuxième entrée et la sortie de l'additionneur étant :

- soit connectées pour générer une sortie $FO_{ij}$ de la dernière cellule et $FO_j$, respectivement,
- soit connectées pour générer une sortie $S_{ij}$ de la dernière cellule et $S_j$, respectivement.

*Fig.2*

*Fig.1*

18

Fig.3

EP 2 092 675 B1

2

4

$Ext.E_0$

$CL_0$
$E_0$  $S_0$
$BO_0$  $BI_0$
$FI_0$  $FO_0$
$TO_0$

$CL_1$
$E_1$  $S_1$
$BO_1$  $BI_1$
$FI_1$  $FO_1$
$TO_1$

$S_j$
$BO_j$
$FO_j$

10

12

14

6

$BIBO_{12}$  $SE_{12}$  $CL_2$
$E_2$  $S_2$
$BO_2$  $BI_2$
$FI_2$  $FO_2$
$FOFI_{12}$
$TO_2$

$CL_3$
$E_3$  $S_3$
$BO_3$  $BI_3$
$FI_3$  $FO_3$
$TO_3$

$BIBO_{34}$  $SE_{34}$  $CL_4$
$E_4$  $S_4$
$BO_4$  $BI_4$
$FI_4$  $FO_4$
$FOFI_{34}$
$TO_4$

$CL_5$
$E_5$  $S_5$
$BO_5$  $BI_5$
$FI_5$  $FO_5$
$TO_5$

$RC_1$  $RC_2$
$RC_3$  $RC_4$
$RC_5$  $RC_6$
$RC_7$  $RC_8$
$RC_0$

$SR_1$
$SR_2$
$SR_3$
$SR_4$

$BIBO_{56}$  $SE_{56}$  $CL_6$
$E_6$  $S_6$
$BO_6$  $BI_6$
$FI_6$  $FO_6$
$FOFI_{56}$
$TO_6$

$CL_7$
$E_7$  $S_7$
$BO_7$  $BI_7$
$FI_7$  $FO_7$

$BIBO_{78}$  $SE_{78}$  $CL_8$
$E_8$  $S_8$
$BO_8$  $BI_8$
$FI_8$  $FO_8$
$FOFI_{78}$

*Fig.4*

$FI_0$   $FI_1$   $FI_2$   $FI_3$   $FI_4$   $FI_5$   $FI_6$   $FI_7$   $FI_8$

$FO_0$ — — — — — — — — — — $FOFI_{0,8}$

$FO_1$

$FO_2$

$FO_3$

$FO_4$

$FO_5$

$FO_6$

$FO_7$

$FO_8$ — — — — — — — — — $FOFI_{87}$

*Fig.4A*

Fig. 5

Fig.6

Fig.7

23

Fig.8

Fig.12A

EP 2 092 675 B1

Fig.9

EP 2 092 675 B1

Fig.10

Fig.11

Fig.12B

Fig.13A

Fig.13B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6807155 B
- US 2001025358 A1, EIDSON DONALD BRIAN
- US 6751772 B1
- US 5703882 A, JUNG HEE YOUNG
- EP 1381179 A